# EUROPEAN PATENT APPLICATION

(11) **EP 4 672 606 A1**
(43) Date of publication of application: **31.12.2025**
(21) Application number: 24184265.7
(22) Date of filing: 25.06.2024
(51) Int. Cl.: H03K 17/06, H03K 17/10, H03K 17/567, H03K 17/687

(54) **A HIGH ELECTRON MOBILITY TRANSISTOR, HEMT, STRUCTURE HAVING A GATE, A SOURCE AND A DRAIN, AS WELL AS A METHOD OF OPERATING SUCH A HEMT STRUCTURE**

(71) Applicant: Nexperia B.V., 6534 AB Nijmegen (NL)
(72) Inventor: Horcajo, Sara Martin, Manchester (GB); Parkin, Jim, Manchester (GB); Brown, Adam, Manchester, SK7 5BJ (GB); Sherman, Daniel, Manchester (GB)
(74) Representative: Pjanovic, Ilija

(57) **Abstract**

A High Electron Mobility Transistor, HEMT, structure (1) having a gate (G), a source (S) and a drain (D), said HEMT structure comprising a depletion-mode transistor (3) having a breakdown voltage, current limiting means (9) arranged for ensuring that a drain source current of said HEMT structure, in an off-state of said HEMT structure, is at most 20 nA/mm, being a current per unit gate length of the depletion-mode transistor, wherein the HEMT structure may comprise a cascode configuration of said depletion-mode transistor with an enhancement mode transistor (6). The current limiting means may be embodied by a bleed resistor 9 that may additionally prevent the enhancement-mode transistor to enter avalanche. The bleed resistor may be connected between the gate terminal of the enhancement-mode transistor and the source terminal of the enhancement-mode transistor.

## Description

### Technical field

The present disclosure relates to the field of operation of HEMT structures and, more specifically, to increasing the reliability of HEMT structures in the off-state.

### Background

A High Electron Mobility Transistor, HEMT, structure is a type of field-effect transistor known for, amongst other, its high-speed and high-frequency performance. It may achieve improved electron mobility by utilizing a heterojunction, which is a junction between two different semiconductor materials with varying band gaps, such as gallium arsenide, GaAs, and aluminum gallium arsenide, AlGaAs.

This structure creates a two-dimensional electron gas at the interface of the materials, allowing electrons to move with very high mobility. The result is a transistor that can operate at higher frequencies, for example up to the millimeter-wave band, making it a good choice for applications in telecommunications, radar systems, and high-speed digital circuits. HEMTs also exhibit low noise levels and good power efficiency, enhancing their suitability for advanced communication systems and medical imaging technologies.

An example may include a so-called cascode HEMT structure. This configuration involves two transistors connected in series. A first transistor (Q1) is typically an enhancement-mode transistor, operating in a common-source configuration. The second transistor (Q2) is often a depletion-mode transistor, operating in, for example, a common-gate configuration.

The main device in the HEMT structure is the depletion mode transistor. Such a transistor is typically fast, it may have low resistance compared to other device. One of the downsides is that the depletion mode transistor is normally-on. The advantage of the above described cascode HEMT structure is that the depletion mode transistor is combined with a enhancement mode transistor such that the device is normally-off.

The cascode configuration offers several advantages, including a robust and reliable insulated gate structure, high gate threshold voltage, and compatibility with standard gate drivers.

Despite a slight increase in ON-resistance, RDS(on), and Reverse Recovery Charge, QRR, these increases are minimal and outweighed by the benefits of stable high-power operation and improved voltage blocking capabilities. This makes the cascode mode particularly suitable for high-voltage, high-current, and high-power applications, including automotive applications where reliability and robustness are crucial.

The cascode GaN FETs, for example, ensure stable performance, easy control of slew rate, and superior reverse recovery characteristics, making them a suitable choice for 650 V GaN FETs in demanding applications.

For the effective deployment of HEMT structures, ensuring their reliability and longevity may be of importance. The materials used in HEMTs, such as GaN and AlGaN, may be of high quality to withstand high voltages and temperatures typically encountered in high-frequency operations. Additionally, proper thermal management may be required to dissipate heat efficiently and prevent degradation of the device over time.

HEMT structures may thus offer advantages in performance and efficiency. It is an object to make sure that these structures are reliable, i.e. their lifespan is improved.

### Summary

It would be advantageous to achieve a High Electron Mobility Transistor, HEMT, structure which has an improved life span. It would further be advantageous to achieve a method of operating such a HEMT structure.

In a first aspect of the present disclosure, there is provided a High Electron Mobility Transistor, HEMT, structure having a gate, a source and a drain, said HEMT structure comprising:
- a depletion-mode transistor having a breakdown voltage,
- current limiting means arranged for ensuring that a drain source current of said HEMT structure, in an off-state of said HEMT structure, is at most 20 nA/mm, being a current per unit gate length of the depletion-mode transistor.

The inventors have found that it may be beneficial to keep the drain source current of the HEMT structure, when the HEMT structure is in the off state, relatively low, i.e. below 20 nA/mm, being the current per unit gate length of the depletion-mode transistor, would significantly improve the reliability.

This drain source current refers to a relatively small amount of current that flows between the drain and source terminals when the HEMT structure is in the off state.

It was found that keeping the leakage current through the HEMT structure in the off-state low will significantly improve the reliability of the HEMT structure.

This is defined, by the present application in a current being at most 20 nA/mm, which means that for every millimeter of gate width, the maximum drain source current is 20 nanoamps, nA, when the transistor is in the off-state.

In an example, the HEMT further comprising:
- an enhancement-mode transistor connected in series with said depletion-mode transistor, wherein a drain of said enhancement-mode transistor is connected to a source of said depletion-mode transistor.

This particular example describes a cascode HEMT structure, wherein an enhancement-mode transistor is connected in series with the depletion-mode transistor. The advantage of this particular example is that the HEMT structure can be operated in a normally-off situation instead of a more traditional normally-on situation.

In an example, a source of said enhancement-mode transistor is connected to a gate of said depletion-mode transistor, and wherein the current limiting means further comprise:
- a bleed resistor.

As elucidated above, the HEMT structure may be related to a d-mode GaN HEMT structure in cascode configuration.

The d-mode, i.e. depletion-mode, GaN HEMT, Gallium Nitride High Electron Mobility Transistor, in a cascode configuration improves high-frequency and high-power performance by pairing a depletion-mode GaN HEMT with an enhancement-mode silicon MOSFET. In such a structure, the GaN HEMT's source connects to the MOSFET's drain. The MOSFET's gate receives the input signal.

This configuration reduces the Miller effect, enhancing bandwidth and frequency response. The GaN HEMT handles high voltages and rapid switching due to its high electron mobility and wide bandgap, while the silicon MOSFET controls the operation at lower voltages.

This arrangement offers significant advantages, including high-speed operation, improved efficiency, reduced thermal stress, and better high-frequency performance, making it ideal for RF amplifiers, power amplifiers, and switch-mode power supplies. Ensuring reliability and longevity involves using high-quality materials, effective thermal management, and careful circuit design to prevent overstressing the transistors.

Addressing these factors maximizes the lifespan of d-mode GaN HEMT structures, ensuring their long-term reliability and effectiveness in demanding applications.

The operation of the cascode HEMT in accordance with the present disclosure is now elucidated in more detail.

First, the on-state operation is considered. This means that a sufficiently high voltage is provided to the enhancement mode transistor for example the MOSFET. This will turn the MOSFET on. In other words, there is almost no voltage dropped across the MOSFET. This will ensure that the gate-source bias of the depletion mode transistor, i.e. the HEMT, is very low, for example close to zero voltage. This will ensure that the HEMT is turned on as it is a depletion mode transistor.

Second, the off-state operation is considered. Here, the present disclosure plays an important role.

When the gate voltage of a MOSFET is relatively low, for example around 0V, it behaves like a high-resistance path. This characteristic allows it to withstand high voltages between its source and drain without allowing significant current to flow through. In contrast, a HEMT under similar conditions remains on, permitting current to flow from its drain through a bleed resistor to its source terminal.

As the voltage at the drain of the HEMT increases, the current through it also increases. Simultaneously, the voltage at the source terminal becomes more negative due to the current flowing through the bleed resistor. This relationship underscores an inverse proportionality between the drain-source voltage of the HEMT structure and its gate-source voltage during its off-state. Lowering the gate-source voltage effectively turns off the HEMT, particularly since HEMTs are depletion-mode transistors.

In practical terms, the off-state behavior of the HEMT involves initial dependency on the drain-source voltage and the resistance value of the bleed resistor. Increasing the drain-source voltage eventually leads to the complete turn-off of the HEMT, resulting in the addition of ohmic resistance for the current flowing from drain to source.

In an example, a value of the bleed resistor is based on a threshold voltage of the of the depletion-mode transistor.

In an example, a source of said enhancement-mode transistor is connected to a gate of said depletion-mode transistor, and wherein the current limiting means comprises:
- a bleed resistor.

The breakdown voltage BVdss of the enhancement mode transistor is selected to be greater than the negative threshold voltage, Vth, of the depletion mode transistor.

The value of the bleed resistor may be based on the negative threshold voltage, Vth, of the depletion mode transistor. It defines the off-state current, loff, of the depletion mode transistor

The above described example allows for a good cascode biasing such that enhancement-mode transistor avalanche is prevented.

In yet another example, the current limiting means comprises:
- a gate driver arranged for negatively biasing a gate-source junction of the depletion-mode transistor, wherein a magnitude of the corresponding negative bias is such that the drain source current of the HEMT structure, in the off-state thereof, is at most 20 nA/mm.

The magnitude of the negative bias provided to the gate-source junction of the depletion-mode transistor determines the level of the leakage current in the off-state. It was found that it may be beneficial to ensure that the negative bias is sufficiently negative, during the whole life time of the HEMT structure, such that the reliability and life span of the HEMT structure is improved.

In an example, the enhancement mode transistor is a Metal-Oxide-Semiconductor, MOS, Field Effect Transistor, FET.

In a further example, the depletion mode transistor is a GaN High Electron Mobility Transistor.

In a second aspect of the present disclosure, there is provided a method of operating a HEMT structure in accordance with any of the previous examples, wherein the method comprises the steps of:
- providing the HEMT structure in the off-state such that the drain source current of the HEMT structure, in the off-state thereof, is at most 20 nA/mm, being a current per unit gate length of the depletion-mode transistor.

It is noted that the advantages as explained with reference to the first aspect of the present disclosure, being the HEMT structure, are also applicable to the second aspect of the present disclosure, being the method of operating the HEMT structure.

In a specific example, the drain-source current of said HEMT structure is at most 20nA/mm each time said HEMT structure is provided in said off-state.

In yet another example, the HEMT structure further comprising an enhancement-mode transistor connected in series with said depletion-mode transistor, wherein a drain of said enhancement-mode transistor is connected to a source of said depletion-mode transistor, and wherein the current limiting means further comprises a bleed resistor, wherein said step of providing comprises:
- providing the HEMT structure in the off-state such that the bleed resistor ensure that, in the off-state, the drain source current of the HEMT structure is at most 20 nA/mm.

In another example, the current limiting means further comprise a gate driver, wherein the method comprises the step of:
- negatively biasing, by said gate driver, a gate-source junction of the depletion-mode transistor, wherein a magnitude of the corresponding negative bias is such that the drain source current of the HEMT structure, in the off-state thereof, is at most 20 nA/mm.

In a specific example, the value of the bleed resistor is based on a rated breakdown voltage of the depletion-mode transistor.

More specifically, an impedance value of the bleed resistor is equal to, or higher than, the rated breakdown voltage divided by the drain source current of said HEMT structure, in the off-state of said HEMT structure.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig.1 depicts the HEMT structure comprising the depletion-mode transistor and the enhancement mode transistor, in accordance with the present disclosure.
Fig. 2 depicts a flow chart showing a method of operating an electronic component in accordance with the present disclosure.
Fig. 3 discloses a graph indicating the source drain current versus the gate bias.
Fig. 4 discloses a graph indicating the source drain current versus the drain source voltage, for a cascode HEMT structure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

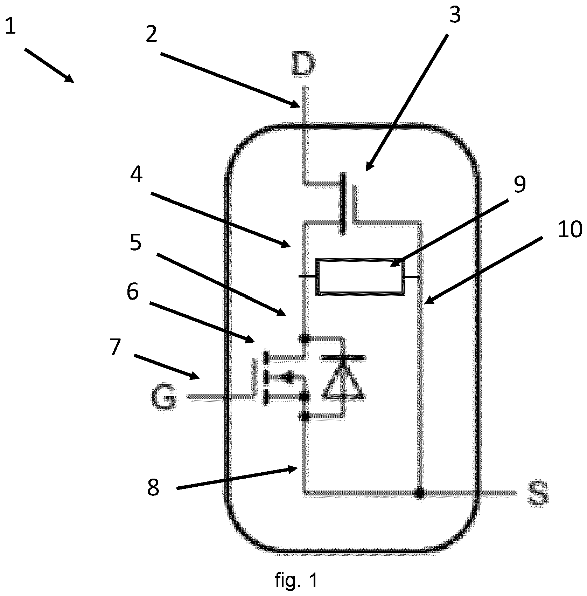

Fig. 1 discloses the HEMT structure 1 comprising the depletion-mode transistor 3 as well as the enhancement mode transistor 6. The depletion-mode transistor 3 may be associated with a breakdown voltage. The depletion-mode transistor may be a 650 Volt rated HEMT.

The depletion-mode transistor 3 comprises a drain terminal 2, a gate terminal 10 and a source terminal 4. The depletion-mode transistor may be connected in with an enhancement-mode transistor 6.

The enhancement-mode transistor 6 comprises a drain terminal 5, a source terminal 8 and a gate terminal 7. The enhancement-mode transistor may be implemented as a Metal Oxide Semiconductor, MOS, Field Effect Transistor, FET. Such a MOSFET may be a 30 Volt rated MOSFET, for example.

The inventors have found that it may be beneficial to restrict the drain-source current of the HEMT structure. The drain-source current of the HEMT structure may be restricted, in an off-state of the HEMT structure, to at most 20 nA/mm, being a current per unit gate length of the depletion-mode transistor.

The total amount of drain source current may be calculated by multiplying the 20nA/mm by the actual gate length of the depletion-mode transistor in millimeters.

The above may be accomplished using a bleed resistor 9. One of the additional advantages of a bleed resistor is that it may prevent the enhancement-mode transistor to enter avalanche. The bleed resistor may be connected between the gate terminal of the enhancement-mode transistor and the source terminal of the enhancement-mode transistor.

The value of the bleed resistor may be based on the negative threshold voltage, Vth, of the depletion mode transistor. It defines the off-state current, loff, of the depletion mode transistor.

As an alternative to the above, or in addition to the above, the drain source current can be controlled by using adequate control signals. The control signals are the signals provided to the gate of the HEMT structure, i.e. the gate of the enhancement-mode transistor. The magnitude of this signal may, at least partly, determine the drain source current through the HEMT structure. As such, a driver may be chosen that is able to provide a control signal, i.e. a negative bias signal, to the gate terminal of the depletion-mode transistor wherein the magnitude of that control signal is high enough to ensure that the drain-source current is lower than 20 nA/mm gate unit length.

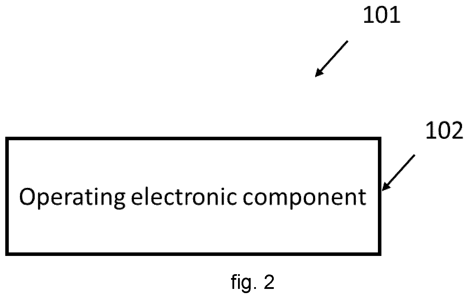

Fig. 2 discloses a method 101 of operating an electronic component in accordance with the present disclosure.

The method comprises the step of operating 102 the electronic component such that the drain source current of the depletion-mode transistor, in an off-state thereof, is at most 20 nA/mm, being a current per unit gate length of the depletion-mode transistor.

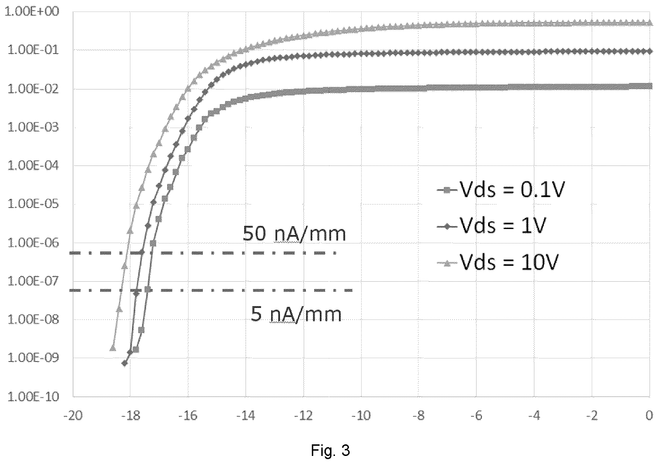

Fig. 3 discloses a graph indicating the source drain current versus the gate bias.

The source drain current is depicted on the vertical axis. The gate bias is depicted on the horizontal axis. Three different examples are shown, i.e. for different drain source voltages of the HEMT structure.

As shown, by reducing the gate voltage to below about -17 volts, the drain source current will be sufficiently low. That is, the drain source current will be below the threshold of 20nA/mm gate length.

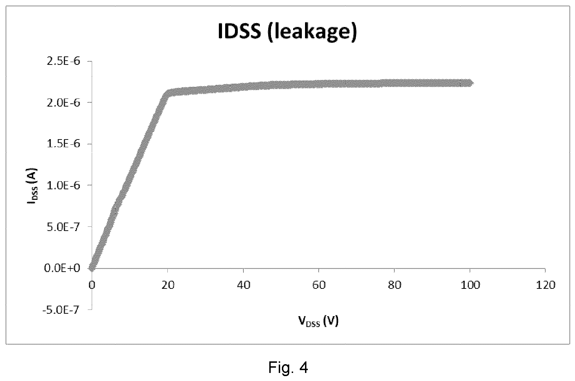

Fig. 4 discloses a graph indicating the source drain current versus the drain source voltage. The graph basically consists of two parts. The first part relates to the part where the drain source voltage is between 0V and about 18V. Here, the depletion mode transistor, i.e. the HEMT, will not be turned off such that current flows from the drain terminal via the HEMT and the bleed resistor into the source terminal. The second part relate to the part where the drain source voltage is above 18V. In this case, the gate source voltage of the HEMT becomes more and more negative such that the HEMT is turned off. The gate source voltage becomes negative due to the fact that the current is flowing through the bleed resistor which creates a voltage drop over the bleed resistor. This voltage drop causes the gate source voltage of the HEMT.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

## Claims

1. A High Electron Mobility Transistor, HEMT, structure having a gate, a source and a drain, said HEMT structure comprising:
- a depletion-mode transistor having a breakdown voltage,
- current limiting means arranged for ensuring that a drain source current of said HEMT structure, in an off-state of said HEMT structure, is at most 20 nA/mm, being a current per unit gate length of the depletion-mode transistor.

2. A HEMT in accordance with claim 1, wherein said HEMT further comprising:
- an enhancement-mode transistor connected in series with said depletion-mode transistor, wherein a drain of said enhancement-mode transistor is connected to a source of said depletion-mode transistor.

3. A HEMT structure in accordance with claim 2, wherein a source of said enhancement-mode transistor is connected to a gate of said depletion-mode transistor, and wherein the current limiting means comprises:
- a bleed resistor.

4. A HEMT structure in accordance with claim 3, wherein a value of the bleed resistor is based on a threshold voltage of the of the depletion-mode transistor.

5. A HEMT structure in accordance with claim 4, wherein an impedance value of the bleed resistor is equal to, or less than, the rated breakdown voltage of the enhancement-mode transistor divided by the drain source current of said HEMT structure, in the off-state of said HEMT structure.

6. A HEMT structure in accordance with any of the previous claims, wherein said current limiting means comprises:
- a gate driver arranged for negatively biasing a gate-source junction of the depletion-mode transistor, wherein a magnitude of the corresponding negative bias is such that the drain source current of the HEMT structure, in the off-state thereof, is at most 20 nA/mm.

7. The HEMT structure according to any of the claims 2 - 6, wherein the enhancement mode transistor is a Metal-Oxide-Semiconductor, MOS, Field Effect Transistor, FET.

8. The HEMT structure according to any of the previous claims, wherein the depletion mode transistor is a GaN High Electron Mobility Transistor.

9. A method of operating a HEMT structure in accordance with any of the previous claims, wherein the method comprises the steps of:
- providing the HEMT structure in the off-state such that the drain source current of the HEMT structure, in the off-state thereof, is at most 20 nA/mm, being a current per unit gate length of the depletion-mode transistor.

10. A method in accordance with claim 9, wherein said drain-source current of said HEMT structure is at most 20nA/mm each time said HEMT structure is provided in said off-state.

11. A method in accordance with any of the claims 9 - 10, wherein said HEMT structure further comprising an enhancement-mode transistor connected in series with said depletion-mode transistor, wherein a drain of said enhancement-mode transistor is connected to a source of said depletion-mode transistor, and wherein the current limiting means further comprises a bleed resistor, wherein said step of providing comprises:
- providing the HEMT structure in the off-state such that the bleed resistor ensure that, in the off-state, the drain source current of the HEMT structure is at most 20 nA/mm.

12. A method in accordance with claim 11, wherein a value of the bleed resistor is chosen based on a rated breakdown voltage of the depletion-mode transistor, and wherein an impedance value of the bleed resistor is preferably equal to, or higher than, the rated breakdown voltage divided by the drain source current of said HEMT structure, in the off-state of said HEMT structure.

13. A method in accordance with any of the claims 9 - 12, wherein the current limiting means further comprise a gate driver, wherein the method comprises the step of:
- negatively biasing, by said gate driver, a gate-source junction of the depletion-mode transistor, wherein a magnitude of the corresponding negative bias is such that the drain source current of the HEMT structure, in the off-state thereof, is at most 20 nA/mm.
